Europäisches Patentamt

European Patent Office

Office européen des brevets

(11) Veröffentlichungsnummer: **0 411 270 A1**

(19)

# EUROPÄISCHE PATENTANMELDUNG

(12)

(21) Anmeldenummer: 90110424.0

(51) Int. Cl.⁵: **B23K 1/20**

(22) Anmeldetag: 01.06.90

(30) Priorität: 30.06.89 DE 3921444

(43) Veröffentlichungstag der Anmeldung:
06.02.91 Patentblatt 91/06

(84) Benannte Vertragsstaaten:
**DE ES FR GB IT**

(71) Anmelder: **ROBERT BOSCH GMBH**
**Postfach 10 60 50**
**D-7000 Stuttgart 10(DE)**

(72) Erfinder: **Leibfried, Wolfgang, Dipl.-Phys.**
**Oberer Burghalde 20**
**D-7250 Leonberg(DE)**
Erfinder: **Zimmermann, Herbert**
**Lindenweg 3**
**D-7141 Freiberg/Heutingsheim(DE)**
Erfinder: **Steinle, Klaus**
**Eschenbruennlestrasse 90**
**D-7032 Sindelfingen(DE)**
Erfinder: **Stecher, Guenther, Dipl.-Phys.**
**Seestrasse 64**
**D-7140 Ludwigsburg(DE)**

(54) **Verfahren zum Aufbringen einer Lotschicht.**

(57) Es wird ein Verfahren zum Aufbringen einer Lotschicht auf Dickschicht-Metallisierungen von Substraten, insbesondere keramischer Substrate, vorgeschlagen, bei welchem eine Lotschicht vor dem Kontaktlöten auf die Dickschicht-Metallisierung aufgeschmolzen wird. Dadurch wird die Benetzung der Dickschicht-Metallisierung verbessert und die Fertigungssicherheit, die Qualität sowie die Langzeitstabilität von Lötkontakten auf Dickschicht-Metallisierungen gesteigert.

EP 0 411 270 A1

## VERFAHREN ZUM AUFBRINGEN EINER LOTSCHICHT

Stand der Technik

Die Erfindung betrifft ein Verfahren zum Aufbringen einer Lotschicht auf Dickschichtmetallisierungen von Substraten, insbesondere keramischen Substraten.

Dickschicht-Metallisierungen bilden relativ komplexe Oberflächen für das Aufbringen von Lötkontakten. Sie sollen gut auf dem Untergrund haften, ein schnelles und sicheres Benetzen ihrer Oberflächen mit Lot gewährleisten und darüber hinaus eine ausreichende Resistenz gegen das Ablegieren in flüssigem Lot aufweisen.

Mit handelsüblichen Dickschichtpasten lassen sich diese Forderungen nicht gleichzeitig optimal erfüllen. Die metallischen Bestandteile der Paste werden entweder reaktiv über spinelle, mit Flußmitteln und/oder mit Glasfritten an die Substratunterlage gebunden. Beim Einbrennen der Pasten läßt es sich dabei kaum vermeiden, daß an der Metallisierungsoberfläche Spuren von Glasern entstehen, die ein Benetzen mit Lot verhindern. Die Ausbildung solcher Gläser wird außerdem noch stark vom Herstellprozeß und von den verwendeten Substratmaterialien beeinflußt. So zeigen gut haftende Dickschicht-Metallisierungen häufig schlechte Benetzungseigenschaften und Metallisierungen mit guter Benetzung legieren rasch ab.

Es ist zwar bekannt, Dickschicht-Metallisierungen vor dem gemeinsamen Löten mit dem Lötpartner mit Lotpasten zu bedrucken, oder die Lötkontakte in flüssiges Lot einzutauchen. Dabei wird der endgültige Lötkontakt zusammen mit dem Lötpartner und relativ viel Lot in einem Arbeitsgang hergestellt. Die Ausbildung der Kontaktschicht auf der Dickschicht-Metallisierung dauert dabei relativ lang. Das für den Kontakt vorgesehene Lot bleibt auf der Metallisierung stehen und fließt nicht aus. Ist das Benetzungsverhalten des Lötpartners besser, so wandert das flüssige Lot vorzugsweise dorthin und fehlt später an entscheidender Stelle. Das Hinausschwemmen von Lunkern ist ebenfalls nicht mehr möglich.

Im Gegensatz hierzu wird gemäß dem Kennzeichen des Hauptanspruchs eine Lotschicht vor dem Löten auf die Dickschicht-Metallisierung aufgeschmolzen. Dies bedeutet, daß die Dickschicht-Metallisierung vor dem eigentlichen Lötprozeß mit möglichst wenig Lot in einem getrennten Vorprozeß für das spätere Zusammenlöten optimal vorbereitet wird. Dadurch ist eine Entkopplung der vorstehend geschilderten Abhängigkeiten und die Herstellung einwandfrei benetzender Dickschicht-Oberflächen auch in solchen Fällen gewährleistet, bei denen eine gute Benetzung zunächst nicht vorhanden war. Außerdem erlaubt das erfindungsgemäße Verfahren einen verbesserten metallurgischen Aufbau der späteren Lötverbindung. Dadurch wird die Qualität und die Zuverlässigkeit der so hergestellten Lötkontakte erhöht. Um Glasschichten aus der Oberfläche von Dickschicht-Metallisierungen zu reduzieren und aufzulösen hat sich vor allem flüssiges Zinn bewährt. Zur Ausbildung einer gut lötfähigen Oberfläche kann daher eine sehr dünne, zinnhaltige Lotschicht auf die Dickschicht-Metallisierung aufgebracht und aufgeschmolzen werden. Dadurch wird die störende Glasschicht beseitigt. Gleichzeitig können sich die für eine gute und schnelle Benetzung notwendigen intermetallischen Verbindungen ausbilden und man erhält als Ergebnis eine für weitere Lötungen sehr gut geeignete Unterlage. Dies gilt auch für ursprünglich recht schlecht benetzende Dickschichtmetallisierungen.

Das Aufbringen des Lotes geschieht zweckmäßigerweise durch einen sehr dünnen Druck einer geeigneten Lotpaste. Die Schichtdicke sollte dabei so gering sein, daß gerade noch eine zusammenhängende und ebene Metalloberfläche entsteht und kein nennenswertes Ablegieren vor dem eigentlichen Lötprozeß auftritt.

Gezielte Untersuchungen deuten darauf hin, daß eine Lotschichtdicke von etwa 10 bis 15 $\mu$m dafür ausreicht. Diese Schichtdicke ist freilich noch von der verwendeten Lotpaste und dem Zustand der Dick- schicht-Metallisierung abhängig.

Das anschließende Aufschmelzen der dünnen Lotschicht erfolgt zweckmäßigerweise unter Schutzgas. Man erhält dann eine Oberfläche, die eben ist (wichtig für eine zuverlässige Montage) und die beim weiteren Löten keine zusätzlichen Flußmittel mehr braucht und deshalb auch nicht mehr gereinigt werden muß.

Außerdem kann man durch die Verwendung ganz bestimmter Lotlegierungen die nicht mit dem später verwendeten Lot zum Zusammenlöten der Lotpartner übereinstimmen müssen, den Grenzbereich der Lotverbindung auch metallurgisch beeinflussen.

In dieser Zone treten vor allem Ermüdungsbrüche gehäuft auf. Sie sind meistens auf eine Verarmung an Sn in der Lotlegierung zurückzuführen. Durch eine gezielte Anreicherung mit Sn oder durch andere metallurgische Maßnahmen im Rahmen eines solchen Lottransfers kann so die Qualität und die Langzeitstabilität der Lötkontakte wesentlich verbessert werden.

Der Kern der Erfindung liegt in einer gezielten Vorbereitung und Verbesserung der Lötfähigkeit von Dickschicht-Metallisierungen mit einem spezifischen Lottransfer und Aufschmelzen einer Lotschicht vor Beginn des eigentlichen Lötprozesses.

Dadurch können beispielsweise sehr gut haftende aber ursprünglich schlecht benetzende Dickschichtpasten in der Fertigung eingesetzt werden. Außerdem wird die Fertigungssicherheit, die Qualität und die Langzeitstabilität von Lötkontakten auf Dickschichtmetallisierungen erheblich verbessert. Dabei ist vor allem das sichere und schnelle Benetzen beim Zusammenlöten mit andern Lötpartnern von Bedeutung.

**Ansprüche**

1. Verfahren zum Aufbringen einer Lotschicht auf Dickschicht-Metallisierungen von Trägersubstraten, insbesondere keramischen Substraten, dadurch gekennzeichnet, daß eine Lotschicht vor dem Kontaktlöten auf die Dickschicht-Metallisierung aufgeschmolzen wird.

2. Verfahren nach Anspruch 1, dadurch gekennzeichnet, daß das Lot als Lotpaste auf die Dickschicht-Metallisierung aufgedruckt und anschließend aufgeschmolzen wird.

3. Verfahren nach Anspruch 1 oder 2 dadurch gekennzeichent, daß das Aufschmelzen der Lotschicht unter Schutzgas erfolgt.

4. Verfahren nach einem der vorhergehenden Ansprüche, dadurch gekennzeichnet, daß die Dicke der aufgeschmolzenen Lotschicht zwischen 10 und 15 ,m beträgt.

5. Verfahren nach einem der vorhergehenden Ansprüche, dadurch gekennzeichnet, daß das Aufschmelzen der Lotschicht auf die Dickschicht-Metallisierung in einem getrennten Vorprozeß erfolgt.

6. Verfahren nach einem der vorhergehenden Ansprüche, dadurch gekennzeichnet, daß die Lotschicht aus einem zinnhaltigen Material besteht.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 274 915 (FORD MOTOR CO. LTD.) <br> * Spalte 4, Zeilen 46,47; Ansprüche * <br> — — — | 1,2,6 | B 23 K 1/20 |
| X | IBM TECHNICAL DISCLOSURE BULLETIN Band 20, Nr. 10, März 1978, Seite 3856, New York, US; J. GOW III et al.: "Modified Cr Dam for MC Metallurgy" <br> — — — | 1,6 | |
| A | idem <br> — — — | 5 | |
| Y | DE-B-1 521 153 (BALZERS HOCHVAKUUM GMBH) <br> * Spalte 3; Ansprüche * <br> — — — | 1,6 | |
| Y | ELEKTRONIK Band 35, Nr. 18, September 1986, Seiten 81-86, München, DE; B. GEISBERGER: "SMT in der Praxis" <br> * Seite 84, rechte Spalte * <br> — — — | 1,2 | |
| A | DD-A-1 038 33 (GLAVERBEL MECANIVER) <br> * Ansprüche 1,10 * <br> — — — — — | 1,3,5,6 | |

**RECHERCHIERTE SACHGEBIETE (Int. Cl.5)**

B 23 K
H 01 L

Der vorliegende Recherchenbericht wurde für alle Patentansprüche erstellt

| Recherchenort | Abschlußdatum der Recherche | Prüfer |
|---|---|---|
| Berlin | 10 Oktober 90 | WUNDERLICH J E |